# EUROPEAN PATENT APPLICATION

(11) **EP 2 720 315 A1**
(43) Date of publication of application: **16.04.2014**
(21) Application number: 13174773.5
(22) Date of filing: 02.07.2013
(51) Int. Cl.: H01Q 1/24, H01Q 1/38, H05K 3/00, H05K 3/10

(54) **Method of manufacturing internal antenna by laser**

(30) Priority: 12.10.2012 KR 20120113690
(71) Applicant: LTS Co., Ltd., Gyeonggi-do 437-817 (KR)
(72) Inventor: Cho, Bum Sang, 437-070 Gyeonggi-do (KR); Jagn, Hyun Jun, 437-070 Gyeonggi-do (KR); Park, Hong Jin, 431-060 Gyeonggi-do (KR)
(74) Representative: Ahner, Philippe

(57) **Abstract**

Disclosed is a method of manufacturing an internal antenna by laser, which includes preparing a case, forming an antenna groove, forming a pattern, and plating. The preparing the case includes preparing the case of the portable terminal. The forming the antenna groove includes emitting a laser beam to the case and thus forming the antennal groove corresponding to an antenna shape. The forming the pattern includes emitting a laser beam to a bottom of the antenna groove and thus forming the engraved pattern. The plating comprises plating an internal portion of the antenna groove with a conductive metallic material.

## Description

### CROSS-REFERENCE TO RELATED APPLICATION

This application claims priority to and the benefit of Korean Patent Application No. 10-2012-0113690 filed in the Korean Intellectual Property Office on October 12, 2012, the entire contents of which are incorporated herein by reference.

### BACKGROUND OF THE INVENTION

### (a) Field of the Invention

The present invention relates to a method of manufacturing an internal antenna by laser, and more particularly to a method of manufacturing an internal antenna by laser, in which a laser beam is emitted to form a groove of a desired antenna shape on a case of a portable terminal and the groove is plated with a conductive metallic material.

### (b) Description of the Related Art

In general, rapid development in information technology (IT) and the like wireless communication field has followed keeping pace with a regular information age. To meet this development, various wireless communication devices such as personal communication service (PCS), a digital cellular system (DCS), a global positioning system (GPS), a personal digital assistant (PDA), a cellular phone, a notebook computer, etc. have been introduced to provide a variety of service to a user through wireless data communication.

Early on such wireless communication devices have mainly provided just telephone service. However, on the strength of a digital convergence trend based on portability and universality, digital multimedia broadcasting (DMB) has been in the limelight as advanced broadcasting and communication convergence service which provide not only various contents such as Internet access, a game, music, a moving picture, etc. but also audio and video service with high quality.

Meanwhile, as the wireless communication devices have been rapidly spread, it becomes a daily necessity for anyone disregarding age and sex. Thus, the competition of the wireless communication device depends on its design aspect, for example, lightweight, thin, simple and small characteristics, a beautiful outer appearance, etc. following a consumer's taste as well as its functional aspect.

Accordingly, in terms of an antenna for improving transmitting/receiving sensitivity, as an essential element of the wireless communication device, there has been conventionally used a road or whip type external antenna protruding at a predetermined length from the wireless communication device and having an omnidirectional radiation characteristic. However, such an external antenna has shortcomings of being frequently damaged, having a design disadvantage, and deteriorating the portability. Accordingly, a built-in antenna, so called an internal antenna, which is embedded in the wireless communication device, has recently been widely used.

In a conventional internal antenna, an antenna groove formed corresponding to an antenna shape is plated with a conductive metallic material. However, the conductive metallic material has a problem with durability. That is, coupling force between polycarbonate for the portable terminal and the conductive metallic material for the internal antenna is so weak that the conductive metallic material can be easily separated from the antenna groove.

### SUMMARY OF THE INVENTION

Accordingly, the present invention is conceived to solve the forgoing problems, and an aspect of the present invention is to provide a method of manufacturing an internal antenna by laser, in which a pattern is formed on a surface of an antenna groove to be plated with a conductive metallic material so as to increase the area and roughness of a contact surface between the antenna groove and the conductive metallic material, thereby improving coupling force between the antenna groove formed in the case of the portable terminal and the conductive metallic material to be plated on the antenna groove.

In accordance with an exemplary embodiment of the present invention, there is provided a method of manufacturing an internal antenna by laser, the method including: preparing a case of a portable terminal; forming an antenna groove corresponding to an antenna shape by emitting a laser beam to the case; forming an engraved pattern by emitting the laser beam to a bottom of the antenna groove; and plating an internal portion of the antenna groove with a conductive metallic material.

The laser beam may have a wavelength of an ultraviolet region.

The forming the antenna groove may include a first emitting step of emitting a laser beam to an edge portion of an area for the antenna groove; a second emitting step of emitting a laser beam to an internal portion of the area for the antenna groove; and a third emitting step of emitting a laser beam to the edge portion of the area for the antenna groove.

The antenna groove may be formed to have a depth of 25 to 35µm.

The engraved pattern may include a plurality of straight lines parallel to and spaced apart from each other.

The engraved pattern may include a plurality of straight lines intersecting each other.

The engraved pattern may include a plurality of looped curves different in size from each other and arranged concentrically.

The engraved pattern may include a plurality of fine holes spaced apart from each other.

### BRIEF DESCRIPTION OF THE DRAWINGS

The above and/or other aspects of the present invention will become apparent and more readily appreciated from the following description of the exemplary embodiments, taken in conjunction with the accompanying drawings, in which:
Fig. 1 is a view showing an example of a case of a portable terminal formed with an internal antenna by a method of manufacturing the internal antenna by laser according to an embodiment of the present invention;
Fig. 2 is a view sequentially showing the method of manufacturing the internal antenna by the laser according to an embodiment of the present invention;
Fig. 3 is a view showing a step of forming an antenna groove in the method of manufacturing the internal antenna by the laser of Fig. 2; and
Figs. 4 to 9 are views showing various examples of the engraved pattern in the method of manufacturing the internal antenna by the laser of Fig. 2.

### DETAILED DESCRIPTION OF THE EMBODIMENTS

Hereinafter, exemplary embodiments of a method of manufacturing an internal antenna by laser according to the present invention will be described with reference to accompanying drawings.

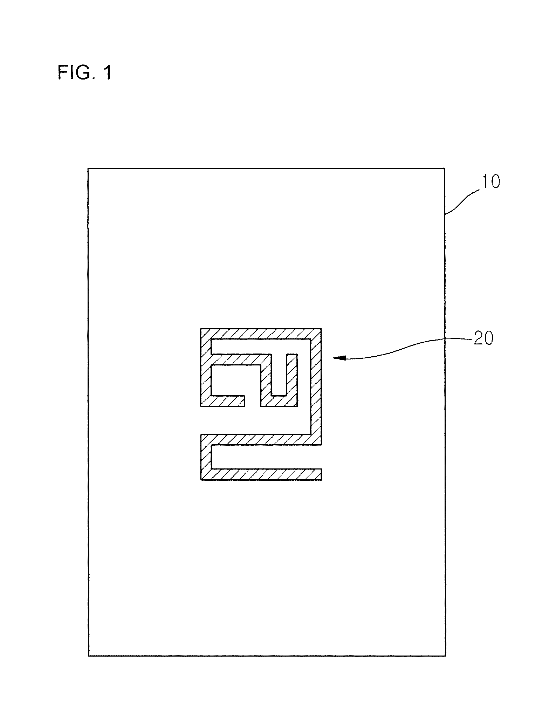

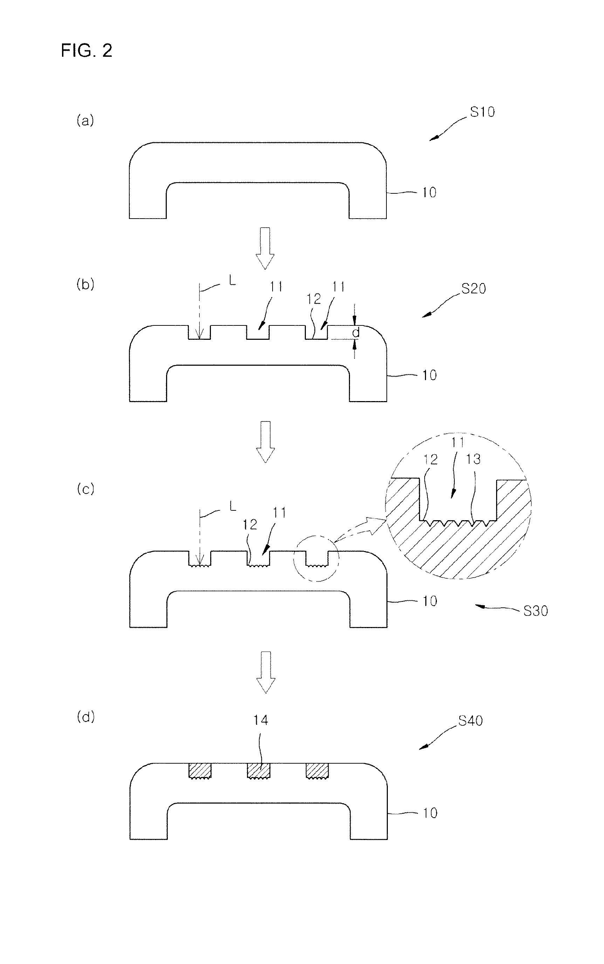

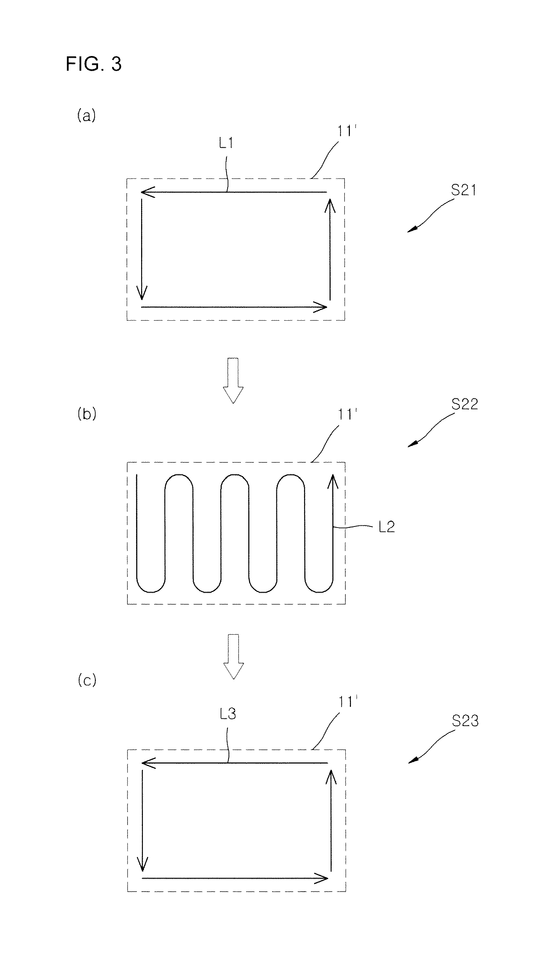

Fig. 1 is a view showing an example of a case of a portable terminal formed with an internal antenna by a method of manufacturing the internal antenna by laser according to an embodiment of the present invention, Fig. 2 is a view sequentially showing the method of manufacturing the internal antenna by the laser according to an embodiment of the present invention, Fig. 3 is a view showing a step of forming an antenna groove in the method of manufacturing the internal antenna by the laser of Fig. 2, and Figs. 4 to 9 are views showing various examples of the engraved pattern in the method of manufacturing the internal antenna by the laser of Fig. 2.

Referring to Figs. 1 to 9, the method of manufacturing the internal antenna by the laser according to an embodiment of the present invention emits a laser beam to form a groove having a desired antenna shape on a case of a portable terminal, and plates the groove with a conductive metallic material, which includes preparing a case (S10), forming an antenna groove (S20), forming a pattern (S30), and plating (S40).

The step S10 of preparing the case includes placing the case 10 of the portable terminal under laser equipment (not shown) of emitting the laser beam L. The case 10 of the portable terminal generally includes a synthetic resin. For example, the case 10 of the portable terminal may be made of polycarbonate.

The step S20 of forming the antenna groove includes emitting the laser beam L to the case 10 and forming the antenna groove 11 corresponding to the shape of an internal antenna 20. The laser beam L emitted to the case 10 in order to form the antenna groove 11 has a wavelength of an ultraviolet region. Specifically, the laser beam L may have a wavelength of about 355 nm.

In the step S20 of forming the antenna groove, the laser beam L is emitted not once but a plurality of times to form the antenna groove 11.

First, as shown in (a) of Fig. 3, at a first emitting step S21, a laser beam L1 is emitted to an edge portion of an area 11' for the antenna groove, thereby removing a case material from the edge portion of the area 11' for the antenna groove.

Then, as shown in (b) of Fig. 3, at a second emitting step S22, the laser beam L2 is emitted to an internal portion of the area 11' for the antenna groove, thereby removing a case material from the internal portion of the area 11' for the antenna groove.

Then, as shown in (C) of Fig. 3, at a third emitting step S23, a laser beam L3 is emitted again to the edge portion of the area 11' for the antenna groove, thereby improving processing quality at the edge portion of the antenna groove 11.

As the laser beam L2 reciprocates in a vertical direction while forming the internal portion of the antenna groove 11 at the second emitting step S22, the edge portion of the antenna groove 11 becomes uneven. If the internal portion of the antenna groove 11 in this uneven state is directly plated with a conductive metallic material 14, plating quality at the edge portion is deteriorated since the edge portion of the internal antenna 20 is not even. Accordingly, the laser beam L3 is emitted once more to the edge portion of the area 11' for the antenna groove through the third emitting step S23, thereby enhancing the processing quality at the edge portion of the antenna groove 11.

The antenna groove 11 formed in the step S20 of forming the antenna groove has a depth of about 25 to 35µm from the surface of the case 10.

The step S30 of forming the pattern includes emitting the laser beam L to form an engraved pattern 13 on a bottom 12 of the antenna groove 11. The laser beam I emitted to form the engraved pattern 13 on the bottom 12 of the antenna groove 11 also has a wavelength of an ultraviolet region. For example, the laser beam I emitted to form the engraved pattern 13 may have a wavelength of about 355nm.

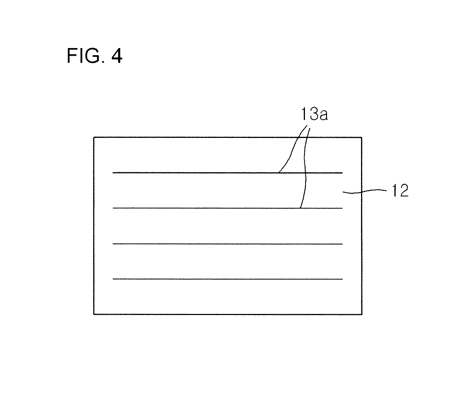

Figs. 4 to 9 show various engraved patterns 13 that may be formed by the method of manufacturing the internal antenna by the laser according to this embodiment.

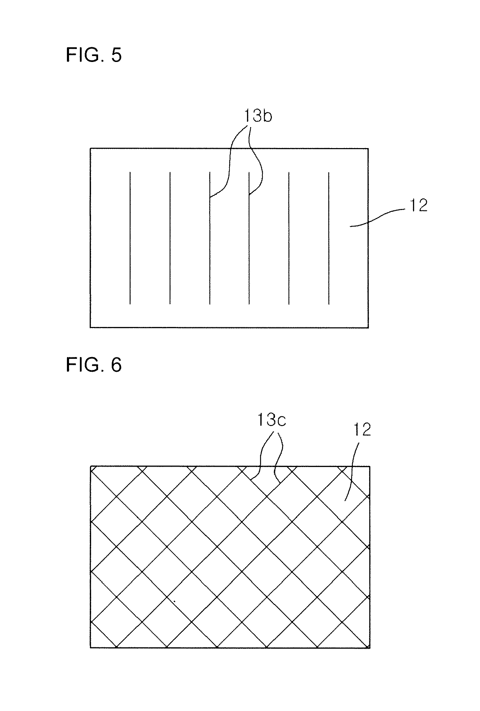

Referring to Figs. 4 and 5, the engraved pattern 13 may be provided in the form of a plurality of straight lines 13a or 13b parallel to and spaced apart from each other. For example, the engraved pattern 13 may have a plurality of horizontal straight lines 13a parallel with a horizontal direction and spaced apart at regular intervals, or a plurality of vertical straight lines 13b parallel with a vertical direction and spaced apart at regular intervals.

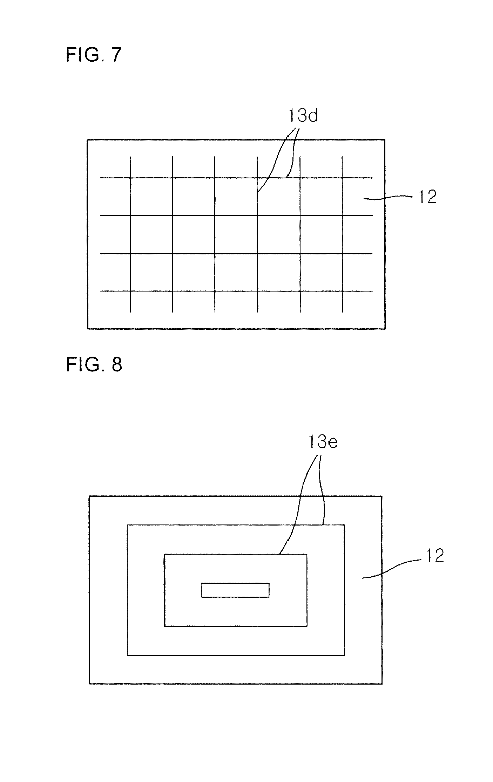

Referring to Figs. 6 and 7, the engraved pattern 13 may be provided in the form of a plurality of straight lines 13c or 13d intersecting each other. For example, the engraved pattern 13 may have a plurality of straight lines 13c intersecting each other at an angle of 45 and 135 degrees, or a plurality of straight lines 13d intersecting each other at an angle of 0 and 90 degrees.

Referring to Fig. 8, the engraved pattern 13 may be provided in the form of a plurality of looped curves 13e different in size from each other but arranged concentrically. Fig. 8 illustrates that the looped curves of the engraved pattern 13 have a rectangular shape, but not limited thereto. Alternatively, the looped curves of the engraved pattern may have various shapes such as a circular shape, etc.

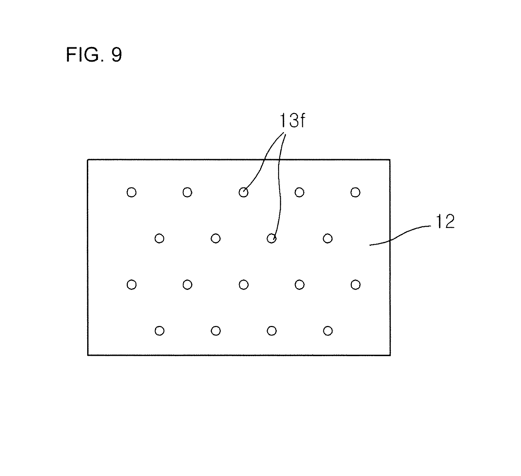

Referring to Fig. 9, the engraved pattern 13 may be provided in the form of a plurality of fine holes 13f spaced apart from each other. The fine hole 13f may be adjusted in diameter, depth, interval, etc. in order to improve coupling force between the antenna groove 11 and the conductive metallic material 14.

The step S40 of plating S40 includes plating the internal portion of the antenna groove 11 with a conductive metallic material 14.

The bottom 12 of the antenna groove formed with the engraved pattern 13 is first plated with nickel or the like conductive metallic material 14 having relatively strong coupling force to the bottom 12, and is then plated with copper or the like conductive metallic material 14 having low electric resistance and practically functioning as the internal antennal. In addition, copper may be coated with a protection layer to thereby finish the step S40 of plating.

With the foregoing configuration, the method of manufacturing the internal antenna by the laser according to this embodiment forms the engraved pattern on the bottom of the antenna groove to be plated with the conductive metallic material in order to increase the coupling force between the antenna groove and the conductive metallic material, thereby having an effect on significantly improving the durability of the internal antennal.

Also, the method of manufacturing the internal antenna by the laser according to this embodiment emits the laser beam once more to the edge portion of the area for the antenna groove in order to make the edge portion of the internal antenna even, thereby having an effect on improving plating quality of the internal antenna.

Although a few exemplary embodiments of the present invention have been shown and described, it will be appreciated by those skilled in the art that changes may be made in these embodiments without departing from the principles and spirit of the invention, the scope of which is defined in the appended claims and their equivalents.

## Claims

1. A method of manufacturing an internal antenna by laser, the method comprising:
preparing a case of a portable terminal;
forming an antenna groove corresponding to an antenna shape by emitting a laser beam to the case;
forming an engraved pattern by emitting the laser beam to a bottom of the antenna groove; and
plating an internal portion of the antenna groove with a conductive metallic material.

2. The method according to claim 1, wherein the laser beam has a wavelength of an ultraviolet region.

3. The method according to claim 1 or 2, wherein the forming the antenna groove comprises
a first emitting step of emitting a laser beam to an edge portion of an area for the antenna groove;
a second emitting step of emitting a laser beam to an internal portion of the area for the antenna groove; and
a third emitting step of emitting a laser beam to the edge portion of the area for the antenna groove.

4. The method according to any of claims 1 to 3, wherein the antenna groove is formed to have a depth of 25 to 35µm.

5. The method according to any of claims 1 to 4, wherein the engraved pattern comprises a plurality of straight lines parallel to and spaced apart from each other.

6. The method according to any of claims 1 to 4, wherein the engraved pattern comprises a plurality of straight lines intersecting each other.

7. The method according to any of claims 1 to 4, wherein the engraved pattern comprises a plurality of looped curves different in size from each other and arranged concentrically.

8. The method according to any of claims 1 to 4, wherein the engraved pattern comprises a plurality of fine holes spaced apart from each other.
